# EUROPEAN PATENT APPLICATION

(11) **EP 4 528 302 A1**
(43) Date of publication of application: **26.03.2025**
(21) Application number: 23198741.3
(22) Date of filing: 21.09.2023
(51) Int. Cl.: G01R 33/3875, G01R 33/38, G01R 33/3815

(54) **MAGNETIC RESONANCE MAGNET ASSEMBLY AND RADIATION SHIELD ASSEMBLY**

(71) Applicant: Koninklijke Philips N.V., 5656 AG Eindhoven (NL)
(72) Inventor: FORTHMANN, Peter, Eindhoven (NL)
(74) Representative: Philips Intellectual Property & Standards

(57) **Abstract**

Disclosed herein is a magnetic resonance imaging (MRI) magnet assembly. The magnet assembly comprises a two-stage cryostat, a primary coil, and a radiation shield assembly. The cryostat comprises a high-temperature stage and a low-temperature stage. The high-temperature stage is adapted for providing an upper working temperature. The primary coil that is thermally coupled to the low-temperature stage. The radiation shield assembly is thermally coupled to the high-temperature stage, and comprises a shim coil and a radiation shield carrying the shim coil. The radiation shield is disposed in the cryostat to shield the primary coil from thermal radiation. When the shield assembly is in thermal equilibrium with the high-temperature stage, the radiation shield has the upper working temperature and thus shields the primary coil from thermal radiation that originates from temperatures above the upper working temperature.

## Description

### FIELD OF THE INVENTION

The invention relates to the field of magnetic resonance imaging systems. In particular, the present invention relates to the area of generating a homogeneous primary magnetic field in a magnetic resonance imaging system.

### BACKGROUND OF THE INVENTION

Modern magnetic resonance imaging (MRI) scanners use a superconducting primary magnet to generate a nearly homogeneous magnetic field (Bo) for providing a magnetic polarization in the sample to be imaged. The quality of an MRI scan depends strongly on the homogeneity of Bo. As slight manufacturing tolerances, asymmetries and disturbances of the magnet assembly are unavoidable, the magnetic field generated by the superconducting magnet must be shimmed, which means applying corrections resulting in a homogeneous magnetic field.

B₀ shimming may be achieved using static and / or dynamic corrections. For static or passive shimming, shims, i.e., pieces made of a material which, when exerted to a magnetic field, locally influences the strength and / or direction of the field (e.g., small shims of a ferromagnetic material such as iron) are fixed at different positions close to the superconducting magnet. Placing shim steel is a well-established process, but there are a few problems connected with it. It is a time-consuming iterative procedure to put all the shims in place. The shim steel is prone to thermal drift during scanning. Steel shims are static. The shims take up space. The last point may be significant when there is little room to integrate them, e.g., in or near the gradient coil.

All these problems can be overcome, at least to some extent, by adding dynamic shim coils into the cryostat. When supplied with a suitable electric current, shim coils generate a magnetic field that removes Bo inhomogeneities by superposition. Shim coils may thus facilitate responding to temporal variations of the field homogeneity and / or may be fine-tuned to cancel out residual inhomogeneities of existing static corrections. Typically, shim coils are resistive coils, usually at room temperature, capable of producing field corrections distributed as several orders of spherical harmonics. The dynamic field corrections may be calibrated automatically by iterations of observing a free induction decay (FID) signal in the absence of field gradients and varying the shim coils' supply currents.

The journal article "Persistent-mode high-temperature superconductor shim coils: A design concept and experimental results of a prototype Z 1 high-temperature superconductor shim" by Y. Iwasa et al., published in Applied Physics Letters 103, 052607 (2013), discloses a superconducting shim coil cut from superconducting yttrium barium copper oxide (YBCO) tape that is positioned inside the magnet assembly.

### SUMMARY OF THE INVETION

The invention provides for an MRI magnet assembly, an MRI scanner, a radiation shield assembly, and a method of assembling an MRI magnet assembly in the independent claims. Embodiments are given in the dependent claims.

In one aspect, the invention provides for a magnetic resonance imaging (MRI) magnet assembly. The magnet assembly comprises a two-stage cryostat. The cryostat comprises a high-temperature stage and a low-temperature stage. The high-temperature stage is adapted for providing an upper working temperature.

The magnet assembly further comprises a primary coil that is thermally coupled to the low-temperature stage.

The magnet assembly further comprises a radiation shield assembly that is thermally coupled to the high-temperature stage. The radiation shield assembly comprises a shim coil and a radiation shield carrying the shim coil. The radiation shield is disposed in the cryostat to shield the primary coil from thermal radiation. When the shield assembly is in thermal equilibrium with the high-temperature stage, the radiation shield has the upper working temperature and thus shields the primary coil from thermal radiation that originates from temperatures above the upper working temperature.

In another aspect, the invention provides for an MRI scanner comprising the MRI magnet assembly.

In another aspect, the invention provides for a radiation shield assembly. The shield assembly is adapted for being installed in a cryostat of an MRI magnet assembly. More particularly, the shield assembly is adapted for being installed in a cryostat having a high-temperature stage and a low-temperature stage. The high-temperature stage of the two-stage cryostat is adapted for providing an upper working temperature.

The MRI magnet assembly further comprises a primary coil. The primary coil is thermally coupled to the low-temperature stage of the cryostat.

The radiation shield assembly comprises a shim coil and a radiation shield carrying the shim coil. The radiation shield is adapted for being disposed in the cryostat to shield the primary coil from thermal radiation. When the shield assembly is in thermal equilibrium with the high-temperature stage, the radiation shield has the upper working temperature and thus shields the primary coil from thermal radiation that originates from temperatures above the upper working temperature.

In another aspect, the invention provides for a method. The method comprises providing a two-stage cryostat. The cryostat comprises a high-temperature stage and a low-temperature stage. The high-temperature stage is adapted for providing an upper working temperature.

The method further comprises providing a primary coil in thermal coupling to the low-temperature stage.

The method further comprises mounting a radiation shield assembly in thermal coupling to the high-temperature stage. The radiation shield assembly comprises a shim coil and a radiation shield carrying the shim coil. The radiation shield is adapted for being disposed in the cryostat to shield the primary coil from thermal radiation. When the shield assembly is in thermal equilibrium with the high-temperature stage, the radiation shield has the upper working temperature and thus shields the primary coil from thermal radiation that originates from temperatures above the upper working temperature.

### BRIEF DESCRIPTION OF THE DRAWINGS

In the following, preferred embodiments of the invention will be described, by way of example only, and with reference to the drawings in which:
Fig. 1 is a cross-sectional representation of a medical system;
Fig. 2 is another cross-sectional representation of a medical system;
Fig. 3 illustrates a two-stage cryocooling setup; and
Fig. 4 shows a radiation shield carrying a shim coil.

### DETAILED DESCRIPTION OF EMBODIMENTS

Like numbered elements in these figures are either equivalent elements or perform the same function. Elements which have been discussed previously will not necessarily be discussed in later figures if the function is equivalent.

Examples may be beneficial because the shim coil is carried by the radiation shield. Thus, the shim coil may not consume valuable space from the bore, i.e., the volume surrounded by the magnet assembly where a patient to be imaged is placed. Similarly, the dynamic shim coil may not take up space in the gradient encoding coil. Placing the shim coils inside the magnet assembly without decreasing the magnet's bore diameter may effectively increase the total shim volume. If the channels for placing iron shims in the room temperature region remain the same size, one may then be able to shim away larger inhomogeneities, or one could make the shim channels smaller, which may enable building thinner gradient coils.

Moreover, as the radiation shield carries the shim coil, the shim coil may be thermally coupled to the radiation shield such that heat generated by the shim coils may be received the radiation shield and transported away to the high-temperature stage of the cryostat. In this way, the shim coil may be efficiently cooled, so that thermal drift of the dynamic shim coil may be counteracted.

In an example, the radiation shield comprises an inner wall that carries the shim coil and is surrounded by the primary coil. The inner wall of the radiation shield is comparably close to the field of view. Thus, to obtain a specific corrective field, the shim coil may be operated with a smaller current compared to an installation of the shim coil at a greater distance from the field of view (FOV). Typically, the radiation shield may be the cold surface closest to the patient.

In another example, the radiation shield comprises an inner surface that faces the primary coil and carries the shim coil. It may be beneficial to mount the shim coil, or a portion of it, on an inner surface of the radiation shield to obtain more free space outside of and immediately neighboring the radiation shield. This free space may then be available for other components of the magnet assembly or the MRI system, which may support a more compact design of the magnet assembly.

In another example, the radiation shield comprises an outer surface that faces away from the primary coil and carries the shim coil. It may be beneficial to mount the shim coil, or a portion of it, on an outer surface of the radiation shield to obtain more free space between the radiation shield and the primary coil. This may also support a more compact design of the magnet assembly. Moreover, portions of the shim coil mounted on an outer surface of the radiation shield may have a larger tolerance for heat generation as thermal radiation emitted by the shim coil in a warm state (i.e., having a temperature exceeding the upper working temperature or the actual temperature of the radiation shield) may get caught by the radiation shield. In this way, additional heat load on the primary coil may be reduced or avoided.

In another example, the radiation shield comprises a groove that carries the shim coil. For instance, the groove may be formed by milling or another structuring technique. The groove may define a particular structure to be assumed by the shim coil. This may support assembling the shim coil on the radiation shield with a higher accuracy. The groove may also enable a higher structural stability of the shim coil, such that it may be less likely that the structure of the shim coil gets altered unintentionally, e.g., during assembly of the magnet assembly or the MRI scanner, by thermal or mechanical movement of the MRI scanner, etc. A high structural accuracy of the shim coil may also support a high quality of MR images by ensuring that the magnetic field generated by the shim coil actually corresponds to the corrective magnetic field intended to be generated by the shim coil. In addition, a groove may be useful to spatially constrain a tape that forms the shim coil but cannot be laid flat on the surface because it can only be bent in one direction.

In another example, the radiation shield comprises the inner wall, an outer wall, and a flange. The outer wall surrounds the primary coil. The flange connects the inner wall to the outer wall and carries the shim coil. This may provide a larger freedom to choose the structure of the shim coil. For instance, the inner wall, the outer wall, and the flange may form a cavity in which the primary coil is disposed. The flange may shield the primary coil from thermal radiation in directions that are covered neither by the inner wall nor the outer wall. Accordingly, the shim coil, or a portion of it, mounted on the flange may be used to generate a magnetic field having orientations that cannot be generated by a shim coil that is carried by the inner wall and / or the outer wall alone. Such flange-mounted shim coil may, for instance, be used to generate magnetic field components pertaining to different spherical harmonics than the components generated by (portions of) shim coil(s) mounted on the inner wall and / or the outer wall. Hence, a greater corrective flexibility and accuracy may be achieved.

In another example, the shim coil is made of a high-temperature superconductor (HTS). In the following, it is assumed that the HTS used to form the shim coil is superconducting at the upper working temperature. Thus, a superconducting shim coil may be obtained. A superconducting shim coil may generate no heat, or a substantially reduced amount of heat due to local residual ohmic resistances, during operation. Compared to typical currents used for operating the primary coil, required currents to drive the shim coil may be small, e.g., in the order of 10 A. HTS conductors of any available size may easily sustain these currents at the upper working temperature. A superconducting shim coil may dissipate no heat into the radiation shield (and the cold mass). Accordingly, no additional heat load may be applied onto the cryostat by the shim coils.

The superconducting shim coil may be operated in persistent mode or in driven mode. Consequentially, requirements of superconductivity of joints and connections to, from and between the superconducting shim coil(s) may be relaxed as these joints may have a residual ohmic resistance. While an ohmic resistor forming the shim coil may have a significantly lower resistance at the upper working temperature (e.g., 40 K) and may thus generate less heat than if operated at room temperature, a superconducting shim coil may reduce the generated amount of heat even further, down to a small amount of heat generated by such possible residual ohmic resistances.

In another example, the high-temperature superconductor is one of MgB₂, Bi₂Sr₂Ca₂Cu₃O₁₀ (BSCCO), and a rare-earth barium copper oxide (ReBCO). These materials may have a higher suitability for forming a stable strand with processing properties that support forming the shim coil from the strand on the radiation shield and operating the shim coil under cryogenic conditions. With its critical temperature of 39 K, MgB₂ may be suitable for a comparably low upper working temperature below 39 K (e.g., 30 K) when operated at comparably low currents.

In another example, the shim coil is a wire or a tape. A wire may have a larger thickness than a tape, which may allow for transporting a given electric current with a lower current density. Moreover, a wire may have a smaller width than a tape, which may allow for defining the corrective magnetic field with a higher precision. A wire may have the further advantage of being bendable in any direction, such that it can be structured into a shim coil with high precision, which may be difficult when using a tape. A beneficial wire material may be Bi2212 (Bi₂Sr₂CaCu₂O₈) which may be formed into, e.g., a round wire and may be reacted after winding, which may increase the designer's freedom of structuring the shim coil. On the other hand, for certain materials, it may be easier to process them into a tape than a wire. A tape may also be beneficial for allowing a stronger adhesion between the radiation shield and the shim coil. It may be feasible to cut a tape into a smaller width to improve its bendability in lateral directions (parallel to the shield surface).

In another example, the radiation shield assembly further comprises a retaining strap that fixes the shim coil to the radiation shield. A retaining strap may yield an improved structural stability of the shim coil. The retaining strap may form an interfacial layer between the shim coil and the radiation shield. The retaining strap may restrict motions of the shim coil relative to the radiation shield, e.g., by facing the shim coil with an adhesive or roughened surface. Additionally or alternatively, the retaining strap may have an adhesive surface facing the radiation shield, and / or may be fixed to the radiation shield in another manner. Furthermore, a retaining strap may improve thermal contact between the radiation shield and the shim coil.

In another example, the radiation shield assembly further comprises a mold that receives the shim coil on the radiation shield. A mold may mechanically guide the shim coil on the radiation shield and may fix the shim coil in a particular structure. Compared to the groove mentioned above, the mold may be provided as a separate component of the radiation shield assembly. Similar to the retaining strap, the mold may have an adhesive surface facing the radiation shield, and / or may be fixed to the radiation shield in another manner. The mold may form a local or continuous fixture for the shim coil, such as one or more retaining clips and / or a support rail.

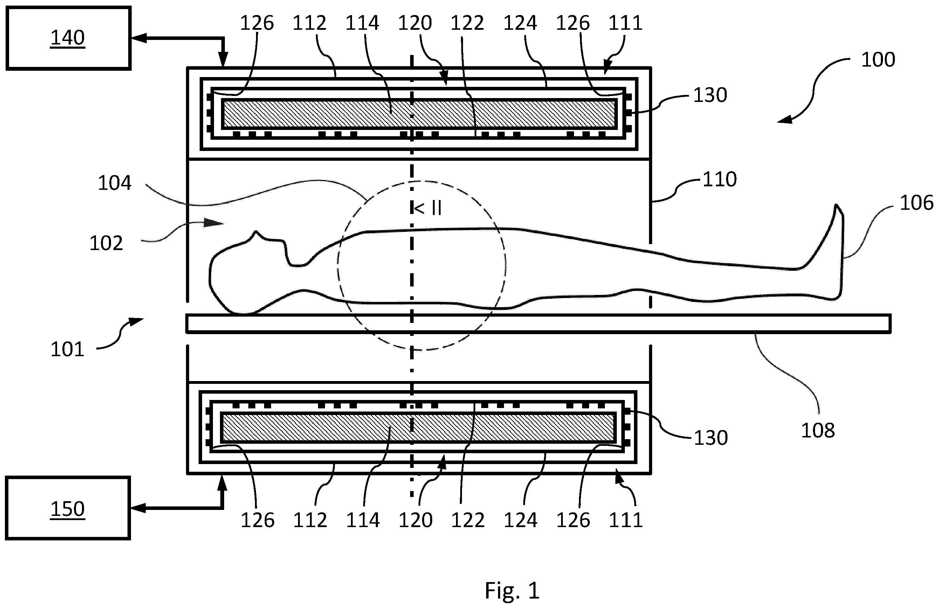

Fig. 1 is a cross-sectional representation of a medical system 100. It is understood that Fig. 1, like any other drawing disclosed herein, serves the sole purpose of illustration and may contain various simplifications and omissions compared to a real medical system. Components not shown in Fig. 1 may include, but are not limited to, gradient coils, transmission coils, receiver coils, power supply components, cryogenic components, etc.

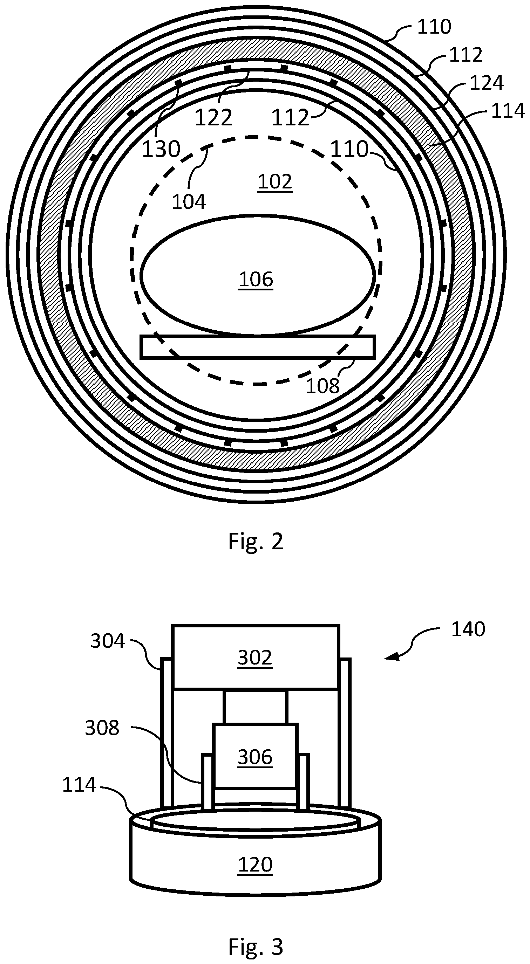

In the non-limiting example of Fig. 1, components of the medical imaging system 101 have a cylinder geometry. The view of Fig. 1 is a cut through the medical system 100 in a plane containing the central axis of the cylindrical geometry. Due to the cylinder geometry, like numbered elements at the top and at the bottom of Fig. 1 may denote a same component of the medical imaging system 101, as can be seen more clearly in Fig. 2. It is understood that a real medical system may comprise local or global deviations from the cylinder geometry shown in Fig. 1.

The medical system 100 may comprise a medical imaging system 101 and a control unit 150. The control unit 150 may be connected to the medical imaging system 101 (e.g., via a bus) and may be configured to control parameters and functions of the medical imaging system 101. In an example, the control unit 150 may be a computer that comprises a processor and memory storing a set of computer-executable instructions which, when executed by the processor, cause the control unit 150 to acquire a medical image using the medical imaging system 101.

The medical imaging system 101 may comprise a housing 110 surrounding a free volume called bore 102 and a subject support 108 configured to place a subject 106 inside the bore 102 such that a portion of the subject 106 is located within an imaging zone 104. When the medical imaging system 101 is used for acquiring a medical image, as described above, the resulting medical image may comprise information representing a portion of tissue of the subject 106 within the imaging zone 104.

The housing 110 may encase an MRI magnet assembly 111 surrounding the bore 102. The magnet assembly 111 may comprise a primary coil 114 that is encased by a radiation shield assembly, that in turn is encased by a two-stage cryostat 112. The primary coil 114 may be supplied with electric currents to be operated as a superconducting magnet. In operation, the primary coil 114 may generate a strong magnetic field, having a typical strength of about 1 Tesla (T) or above, that is nearly homogeneous at least within the imaging zone 104. The primary coil 114 may comprise a superconducting material that is typically a low-temperature superconductor (LTS) such as niobium-titanium (Nb-Ti, NbTi).

The two-stage cryostat 110 may comprise a high-temperature stage and a low-temperature stage, where the high-temperature stage may be adapted for providing an upper working temperature (e.g., 40 to 50 Kelvin (K)) and the low-temperature stage may be adapted for providing a lower working temperature (e.g., 4 K, allowing for liquid-helium cooling). The primary coil 114 may be thermally coupled to the low-temperature stage and the radiation shield assembly may be thermally coupled to the high-temperature stage. When, during operation, the radiation shield assembly is in thermal equilibrium with the high-temperature stage, the radiation shield assembly may have the upper working temperature and may thus shield the primary coil 114 from thermal radiation that originates from temperatures above the upper working temperature.

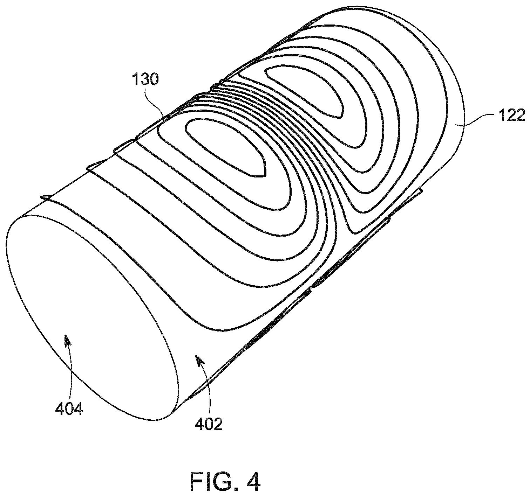

The radiation shield assembly may comprise a radiation shield 120 and one or more shim coil(s) 130 carried by the radiation shield 120. The radiation shield 120 may encase the primary coil 114 with several walls such as an inner wall 122, an outer wall 124, and one or more flange(s) 126 connecting the inner wall 122 and the outer wall 124. The surfaces of the outer wall 124, the inner wall 122, and the flanges 126 facing the primary coil 114 are referred to as inner surfaces 402 of the radiation shield 120, and the surfaces of the outer wall 124, the inner wall 122, and the flanges 126 facing away from the primary coil 114 are referred to as outer surfaces 404 of the radiation shield 120. These surfaces are depicted in an alternative view in Fig. 4.

The shim coil 130 may be formed, for instance, by a wire or a tape that is wound around one or more of the walls of the radiation shield 120. The structure of the shim coil 130 may be stabilized and / or fixed with respect to the radiation shield 120 using, e.g., a groove, a retaining strap, a mold, a glue, a solder, a weld, or a combination thereof. For instance, the shim coil 130 may be glued on a retaining strap that adheres to the radiation shield 120. Likewise, the shim coil 130 may be fixed on the radiation screen 120 by a mold, or may be laid into a groove formed on a surface of the radiation screen 120 (whereby the radiation screen itself may effectively act as a mold). In the example of Fig. 1, one or more shim coils 130 are carried by the inner surface 402 of the inner wall 122 and by the outer surface 404 of the flanges 126.

Besides mechanical contact, the shim coil 130 may be in thermal contact with the radiation shield 120. Thus, the shim coil 130 may be cooled by the radiation screen 120. In particular, the shim coil 130 may be formed using a superconducting material, and more particularly, using a high-temperature superconductor (HTS) that is superconducting at the upper working temperature. Without limitation, exemplary HTS materials that appear suitable for forming the shim coil 130 may include MgB₂, Bi₂Sr₂Ca₂Cu₃O₁₀ ("BSCCO"), or YBa₂Cu₃O₇ ("YBCO").

Fig. 2 is another cross-sectional representation of the medical system 100. The view of Fig. 2 is a cut through the medical system 100 in a plane that is indicated in Fig. 1 by a line denoted "II" and that is orthogonal to the plane of view of Fig. 1. In the non-limiting example of Fig. 2, the housing 110, the walls of the cryostat 112, the outer wall 124 and the inner wall 122 of the radiation shield 120, and the primary coil 114 are set up in a concentric arrangement about the bore 102. It is understood that a real medical system may comprise local or global deviations from the concentric arrangement shown in Fig. 2. Again, the subject 106 and the subject support 108 are located within the bore 102 and surrounded by the components encased by the housing 110, and a portion of the subject 106 is located within the imaging zone 104.

Fig. 3 is a schematic view of a two-stage cryocooling system 140 whose two cooling stages 302, 306 may be used to cool corresponding stages (areas, volumes) of a two-stage cryostat 112. The first cooling stage 302 may contain a cooling apparatus that is adapted for providing an upper working temperature T₁ (e.g., 40 K). Thermal outlets of the first stage 302 are thermally coupled to heat exchangers 304, each of which comprising a lower end that is thermally coupled to corresponding thermal coupling points of the radiation shield 120 installed in the first stage of the two-stage cryostat 112 (not shown). The second stage 302 may contain another cooling apparatus that is adapted for providing a lower working temperature T₂ (e.g., 4 K). Thermal outlets of the second stage 306 are thermally coupled to heat exchangers 308, each of which comprising a lower end that is thermally coupled to corresponding thermal coupling points of the primary coil 114 installed in the second stage of the two-stage cryostat 112. Heat exchange between the cooling stages 302, 306 and the primary coil 114 or, respectively, the radiation shield 120 may be performed using heat conduction through the heat exchangers 304, 308, a gaseous coolant and / or working gas (e.g., helium, hydrogen, nitrogen vapor), a liquid coolant (e.g., liquid helium, hydrogen, nitrogen), or a combination thereof. When the cryocooling system 140 is operated until thermal equilibrium is reached, the radiation shield 120 may be thermalized at the upper working temperature T₁ and the primary coil 114 may be thermalized at the lower working temperature T₂.

The shim coil 130 may be disposed on an inner surface 402 and / or outer surface 404 of any wall of the radiation shield 120.

Fig. 4 shows an example thereof, where an exemplary shim coil 130 is wound around a cylindrical inner wall 122. As the inner and outer surfaces of walls of the radiation shield 120 are defined as above with respect to the primary coil 114, it can be seen that the surface called "inner surface" 402 of the inner wall 122 is located on the radially outward face of the inner wall 122 and the surface called "outer surface" 404 is located on the radially inward face of the inner wall 122.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS

- 100: medical system
- 101: medical imaging system
- 102: bore
- 104: imaging zone
- 106: subject
- 108: subject support
- 110: housing
- 111: magnet assembly
- 112: cryostat
- 114: primary coil
- 120: radiation shield
- 122: inner wall
- 124: outer wall
- 126: flange
- 130: shim coil
- 140: cryocooling system
- 150: control unit
- 302: high-temperature stage
- 304: heat exchanger
- 306: low-temperature stage
- 306: heat exchanger
- 402: inner surface
- 404: outer surface

## Claims

1. An MRI magnet assembly comprising:
- a two-stage cryostat (112) comprising:
- a high-temperature stage adapted for providing an upper working temperature; and
- a low-temperature stage,
- a primary coil (114) thermally coupled to the low-temperature stage, and
- a radiation shield assembly thermally coupled to the high-temperature stage, the radiation shield assembly comprising:
- a shim coil (130), and
- a radiation shield (120) carrying the shim coil, the radiation shield being disposed in the cryostat to shield, when the radiation shield assembly is in thermal equilibrium with the high-temperature stage, the primary coil from thermal radiation originating from temperatures above the upper working temperature.

2. The MRI magnet assembly of claim 1, the radiation shield comprising an inner wall (122) surrounded by the primary coil, the inner wall carrying the shim coil.

3. The MRI magnet assembly of claim 1 or 2, the radiation shield comprising an inner surface (302) facing the primary coil and carrying the shim coil.

4. The MRI magnet assembly of any of the preceding claims, the radiation shield comprising an outer surface (304) facing away from the primary coil and carrying the shim coil.

5. The MRI magnet assembly of any of the preceding claims, the radiation shield comprising a groove carrying the shim coil.

6. The MRI magnet assembly of any of the preceding claims, the radiation shield comprising the inner wall, an outer wall (124) surrounding the primary coil, and a flange (126) connecting the inner wall to the outer wall and carrying the shim coil.

7. The MRI magnet assembly of any of the preceding claims, the shim coil being made of a high-temperature superconductor.

8. The MRI magnet assembly of claim 7, the high-temperature superconductor being one of MgB₂, Bi₂Sr₂Ca₂Cu₃O₁₀, and a rare-earth barium copper oxide.

9. The MRI magnet assembly of any of the preceding claims, the shim coil being a wire or a tape.

10. The MRI magnet assembly of any of the preceding claims, the radiation shield assembly further comprising a retaining strap fixing the shim coil to the radiation shield.

11. The MRI magnet assembly of any of the preceding claims, the radiation shield assembly further comprising a mold receiving the shim coil on the radiation shield.

12. An MRI scanner comprising the MRI magnet assembly according to one of the preceding claims.

13. A radiation shield assembly adapted for being installed in a two-stage cryostat (112) of an MRI magnet assembly, the cryostat comprising:
- a high-temperature stage adapted for providing an upper working temperature; and
- a low-temperature stage,
the MRI magnet assembly further comprising a primary coil (114) thermally coupled to the low-temperature stage, the radiation shield assembly comprising:
- a shim coil (130), and
- a radiation shield (120) carrying the shim coil, the radiation shield being adapted for being disposed in the cryostat to shield, when the radiation shield assembly is in thermal equilibrium with the high-temperature stage, the primary coil from thermal radiation originating from temperatures above the upper working temperature.

14. A method of assembling an MRI magnet assembly, the method comprising:
- providing a two-stage cryostat (112) comprising:
- a high-temperature stage adapted for providing an upper working temperature; and
- a low-temperature stage,
- providing a primary coil (114) in thermal coupling to the low-temperature stage,
- mounting a radiation shield assembly in thermal coupling to the high-temperature stage, the radiation shield assembly comprising:
- a shim coil (130), and
- a radiation shield (120) carrying the shim coil, the radiation shield being disposed in the cryostat to shield, when the radiation shield assembly is in thermal equilibrium with the high-temperature stage, the primary coil from thermal radiation originating from temperatures above the upper working temperature.
